# FASCICULE DE BREVET EUROPEEN

(11) **EP 2 447 209 B1**
(45) Date de publication et mention de la délivrance du brevet: **10.02.2016**
(21) Numéro de dépôt: 11182970.1
(22) Date de dépôt: 27.09.2011
(51) Int. Cl.: B81B 3/00, B81B 7/00

(54) **Microsystème électromécanique (MEMS)**
Mikroelektromechanisches System (MEMS)
Microelectromechanical system (MEMS)

(30) Priorité: 29.10.2010 FR 1004273
(43) Date de publication de la demande: 02.05.2012
(73) Titulaire: Thales, 92200 Neuilly Sur Seine (FR)
(72) Inventeur: Leverrier, Bertrand, 26120 MONTELIER (FR); Lefort, Olivier, 26000 VALENCE (FR); Boura, André, 86100 CHATELLERAULT (FR); Chaumet, Bernard, 86100 CHATELLERAULT (FR)
(74) Mandataire: Brunelli, Gérald

(56) Documents cités:
- WO-A1-02/093180
- WO-A1-03/054477
- WO-A1-2011/000644
- GB-A- 2 444 373
- US-A- 5 203 208
- US-A1- 2004 187 578
- US-B1- 6 230 567

## Description

La présente invention porte sur un microsystème électromécanique (MEMS) muni d'au moins deux éléments de fixation adaptés pour être fixés sur un support, par exemple un boîtier pouvant être sous vide.

Un microsystème électromécanique est un microsystème comprenant un ou plusieurs éléments mécaniques qui utilise l'électricité comme source d'énergie, en vue de réaliser une fonction de capteur et/ou d'actionneur avec au moins une structure présentant des dimensions micrométriques, et dont la fonction du système est en partie assurée par la forme de cette structure. Le terme microsystème électromécanique est la version française de l'acronyme MEMS pour "Microelectromechanical systems" en langue anglo-saxonne. Dans la suite de la description, l'acronyme MEMS pourra être employé comme synonyme de microsystème électromécanique.

Les microsystèmes électromécaniques sont des microstructures obtenues par gravure d'un ou plusieurs substrats de dimensions telles qu'il comprend plusieurs dizaines à plusieurs centaines de microsystèmes électromécaniques. Le conditionnement ou "packaging" en langue anglo-saxonne comprend les moyens et fonctions qui permettent de manipuler ces microsystèmes électromécaniques, pendant l'intégration dans les produits sans risque de dégradation des microsystèmes électromécaniques. Par exemple, il est important de bien gérer les connexions électriques des microsystèmes électromécaniques avec des cartes électroniques de commande.

Les fonctions de conditionnement ont aussi un rôle essentiel pour limiter l'impact de l'environnement externe sur des zones sensibles que sont les microsystèmes électromécaniques.

En effet, les causes de dégradations de performances des microsystèmes électromécaniques peuvent être diverses, telles:
- des contraintes mécaniques liées aux différences de coefficient de dilatation entre les matériaux de la structure d'accueil et les matériaux du microsystème électromécanique ;
- des variations de la pression autour des microsystèmes électromécaniques ;
- des capacités parasites variables sous l'effet de l'humidité ; et
- des contraintes excessives générées par des chocs sur la structure active.

Le conditionnement doit également veiller à maîtriser la position relative du détecteur ou microsystème électromécanique par rapport à son support

Il est connu d'utiliser des technologies de collage ou de brasage pour fixer des microsystèmes électromécaniques sur un support. Un collage ou un brasage est réalisé sur tout ou partie d'une des faces de la structure, en utilisant par exemple des colles dites souples à base de silicone, ou des brasages dits raides à base d'un mélange or/étain.

Toutefois les systèmes connus sont limités en termes de rigidité de fixation et d'alignement entre le détecteur et son support, de compatibilité avec une mise sous vide du détecteur dans un boîtier, et de préservation des performances du microsystème électromécanique.

Un but de l'invention est de pallier les précédents problèmes.

Il est proposé, selon un aspect de l'invention, un microsystème électromécanique muni d'au moins deux éléments de fixation disjoints adaptés pour être fixés sur un support, dans lequel chaque élément de fixation est lié solidairement à au moins une poutre déformable en flexion. Deux poutres liées respectivement à deux éléments de fixation distincts ont des directions différentes. Une poutre a une longueur L, une épaisseur e, et une hauteur h, telles que les raideurs KL selon les directions de la longueur et de la hauteur Kh soient fortes et la raideur selon la direction de l'épaisseur Ke soit faible.

Ainsi, même si le support se déforme, ces déformations ne sont pas transmises au microsystème électromécanique, contrairement aux configurations de l'art antérieur tels que la fixation par collage ou brasure sur des surfaces plus ou moins importantes du microsystème électromécanique qui génère toujours de fortes contraintes et déformations de la structure interne du microsystème électromécanique. Avec la configuration décrite le système de fixation évite la transmission des contraintes et déformations externes tout en assurant une fixation rigide du microsystème caractérisée par des raideurs importantes en translation et en rotation selon tous les axes.

Le support peut être un boîtier, permettant, par exemple, de mettre sous vide le détecteur ou microsystème électromécanique. En effet, pour assurer le fonctionnement de détecteurs MEMS notamment résonant, tels des capteurs inertiels de types gyromètres ou accéléromètres, il faut qu'ils soient au sein d'une enceinte sous vide, plus ou moins poussé, afin de permettre le fonctionnement correct du détecteur MEMS mis en oeuvre, pour pouvoir disposer d'une sensibilité maximale du détecteur MEMS. Ainsi, il est fréquent qu'une pression inférieure à 10⁻² hPa soit nécessaire au bon fonctionnement d'un tel détecteur. Ceux-ci sont donc encapsulés dans une enceinte hermétique, au sein de laquelle le vide requis ou une atmosphère à pression réduite a été réalisé. Il est cependant difficile d'obtenir un niveau de vide de bonne qualité, ou, en d'autres termes, une pression faible, typiquement une pression inférieure à 10⁻² hPa à l'intérieur d'un boîtier de détecteur MEMS sur silicium.

En outre, la raideur globale du système de fixation est importante dans toutes les directions en translation et en rotation.

Par exemple, deux poutres liées respectivement à deux éléments de fixation distincts ont des directions sensiblement orthogonales.

Le fait d'avoir des directions orthogonales, permet de maximiser la raideur globale de la partie suspendue.

Par exemple, le microsystème électromécanique comprend trois éléments de fixation.

Utiliser trois éléments de fixation permet augmente encore la raideur de fixation de la partie suspendue en particulier en rotation autour du centre de gravité.

La ou les poutres liées à deux des trois éléments de fixation peuvent alors avoir une direction sensiblement identique, et la ou les poutres reliées à l'autre des trois éléments de fixation ont une direction sensiblement orthogonale à la direction de ladite ou lesdites autres poutres.

Un tel mode de réalisation permet de maximiser la raideur apportée par le système de poutres

Par exemple, le microsystème électromécanique comprend quatre éléments de fixation.

Utiliser quatre éléments de fixation permet de construire une structure avec un fort degré de symétrie. C'est particulièrement favorable si le microsystème électromécanique fonctionne avec des structures différentielles dont les propriétés sont préservées.

La ou les poutres liées à deux des quatre éléments de fixation peuvent alors avoir une direction sensiblement identique, et la ou les poutres reliées au deux autres des quatre éléments de fixation ont une direction sensiblement orthogonale à la direction de ladite ou lesdites autres poutres.

Un tel mode de réalisation permet de maximiser la raideur apportée par le système de poutres.

Par exemple, les poutres liées solidairement à un même élément de fixation ont sensiblement la même direction.

Cela permet de doubler la raideur globale du système de manière homogène dans toutes les directions.

Un élément de fixation peut être lié solidairement à quatre poutres.

Cela permet, en multipliant le nombre de poutres, d'optimiser le rapport entre la raideur selon l'axe parallèle à la grande longueur des poutres et les raideurs selon les axes perpendiculaires à cette longueur.

Selon un mode de réalisation, ledit microsystème électromécanique étant réalisé dans un matériau multicouches comprenant au moins une couche active et deux couches de protection de part et d'autre de la couche active, lesdites poutres sont réalisées dans l'une des deux couches de protection.

Dans un tel mode de réalisation, le système de poutre est réalisé dans le même matériau que le reste du microsystème, et le caractère homogène du microsystème est préservé. La fabrication est aussi réalisée de manière collective avant ou après l'assemblage de la couche de protection.

Selon un autre aspect de l'invention, il est en outre proposé un procédé de fixation d'un microsystème électromécanique sur un support, en liant au moins deux éléments de fixation disjoints du microsystème électromécanique, en liant solidairement un élément de fixation à au moins une poutre déformable en flexion, deux poutres liées respectivement à deux éléments de fixation distincts ayant des directions différentes, une poutre ayant une longueur L, une épaisseur e, et une hauteur h, telles que les raideurs KL selon les directions de la longueur et de la hauteur Kh soient fortes et la raideur selon la direction de l'épaisseur Ke soit faible.

Par exemple, ladite liaison est effectuée par brasage et/ou soudage et/ou collage.

L'invention sera mieux comprise à l'étude de quelques modes de réalisation décrits à titre d'exemples nullement limitatifs et illustrés par les dessins annexés sur lesquels :
- les figures 1a, 1b et 1c illustrent schématiquement des modes de réalisations d'un microsystème électromécanique muni de deux éléments de fixation, les figures 1b et 1c illustrant un aspect de l'invention ;
- les figures 2a, 2b, 2c et 2d illustrent schématiquement des modes de réalisations de microsystème électromécanique muni de trois éléments de fixation, selon un aspect de l'invention ; et
- les figures 3a et 3b illustrent schématiquement des modes de réalisations de microsystème électromécanique muni de quatre éléments de fixation, selon un aspect de l'invention.

Sur l'ensemble des figures, les éléments ayant les mêmes références sont similaires, et les axes d'orientations sont similaires.

Il est possible de caractériser un système de fixation par la raideur globale de fixation du microsystème selon trois mouvements de translation selon les axes X, Y et Z et trois mouvements de rotation autour de ces trois axes. Le système de fixation sera "idéal" si les six termes de raideur sont de forte valeur et si simultanément les déplacements locaux des zones de fixation ne génèrent pas ou peu de déformations du microsystème. Les différentes figures ci-dessous présentent plusieurs configurations avec des degrés de raideur différents.

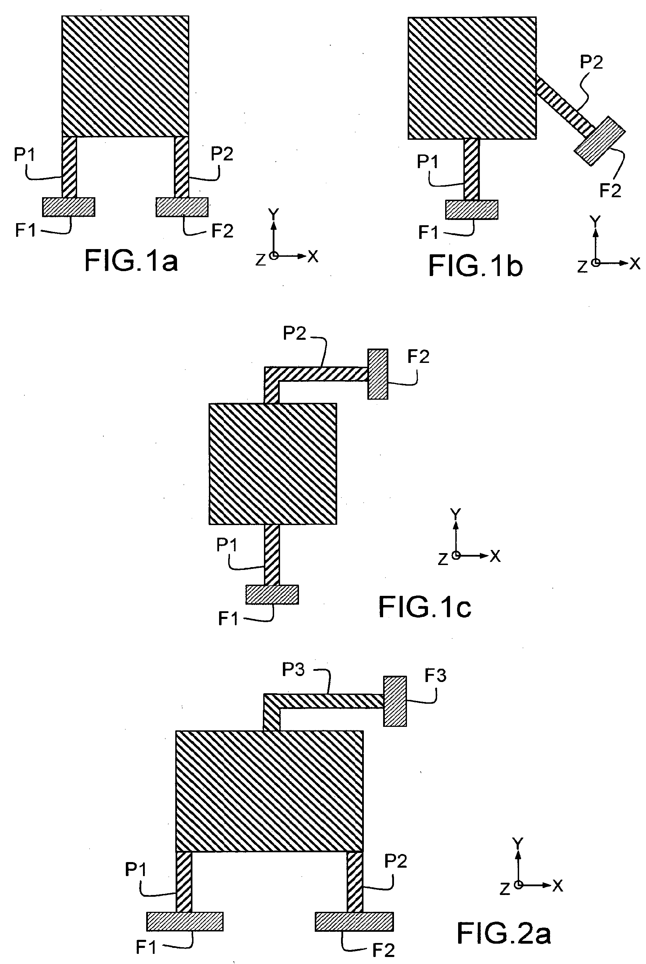

La figure 1 a représente un microsystème électromécanique ne faisant pas partie de l'invention muni de deux éléments de fixation F1 et F2, adaptés pour être fixés sur un support, par exemple un boitier d'encapsulation, au moyen des deux éléments de fixation F1 et F2. Chaque élément de fixation F1 et F2 est respectivement lié solidairement à une poutre P1 et P2 déformable en flexion.

Classiquement une poutre, ou bras de découplage, est définie comme une pièce mécanique parallélépipédique : avec une grande dimension ou longueur L et deux petites dimensions, une épaisseur e et une hauteur h. Les dimensions L, e, et h sont telles que les raideurs KL et Kh respectivement selon les directions de la longueur et de la hauteur soient fortes et la raideur selon la direction de l'épaisseur Ke soit faible. Sur les figures la hauteur H est selon l'axe Z et les longueur L et épaisseur e sont dans le plan XY.

Dans la suite de la description, des valeurs typiques pour une poutre sont : L /e > 20, et h/e > 6, et des valeurs typiques de raideurs KL, Ke et Kh, respectivement selon les dimensions L, e et h telles que : Kh/Ke est de l'ordre de (h/e)² qui vaut environ 36, et KL/Ke est de l'ordre de (L/e)² qui vaut environ 400.

En outre, pour une association de deux poutres identiques disposées en parallèle, pour une épaisseur e donnée, les raideurs KL, Ke et Kh ont respectivement une valeur doublée.

En comparaison, une poutre dont on double l'épaisseur e, multiplierait par deux les raideurs KL et Kh, mais la raideur Ke serait multipliée par huit. A encombrement donné ou à raideur de poutre donnée, selon l'épaisseur e, il est donc mieux de multiplier le nombre de poutres tant que la dimension e est réalisable.

Sur la figure 1a, sont représentés deux poutres P1 et P2, faisant partie du microsystème, disposées parallèles, en considérant les directions de leurs longueurs, reliant la partie principale du détecteur aux deux éléments de fixations F1 et F2 du détecteur.

Un tel mode de réalisation, procure une raideur globale importante selon la direction Y, une raideur modérée selon la direction Z, mais une raideur assez faible selon l'axe X. Cette configuration est par contre très tolérante aux déplacements des zones de fixation selon les trois axes et même en rotation.

La figure 1b représente une variante du mode de réalisation de la figure 1a, dans laquelle les deux poutres P1 et P2, ont des directions respectives différentes, ce qui permet d'augmenter fortement la raideur selon la direction X en augmentant aussi la raideur selon la direction Z.

La figure 1c représente une variante des modes de réalisation des figures 1a et 1b, dans laquelle les deux poutres P1 et P2, ont des directions respectives orthogonales, ce qui permet d'optimiser la raideur en translation selon les trois axes X, Y , et Z pour un système à deux poutres. Les modes de réalisation des figures 1b et 1c sont toujours assez peu sensibles aux déplacements des zones de fixation selon l'axe Z.

La figure 2a représente un microsystème électromécanique dont la partie principale est de forme rectangulaire, muni de trois éléments de fixation F1, F2 et F3, adaptés pour être fixés sur un support, par exemple un boitier d'encapsulation, au moyen des trois éléments de fixation F1, F2 et F3. Chaque élément de fixation F1, F2 et F3 est respectivement lié solidairement à une poutre P1, P2 et P3 déformable en flexion, reliant la partie principale du détecteur aux trois éléments de fixations F1, F2 et F3 du détecteur.

Les deux poutres P1 et P2 ont une direction sensiblement identique, et sont liées à un même bord de la partie principale du détecteur, tandis que la troisième poutre P3 a une direction sensiblement orthogonale à la direction des deux autres poutres P1 et P2, et cette dernière est reliée au bord opposé de la partie principale du détecteur. Par rapport à la structure à deux poutres, un tel mode de réalisation permet de disposer d'une raideur en rotation importante selon les trois axes tout en gardant une raideur en translation importante également selon les trois axes. Cette configuration devient légèrement sensible aux déplacements des zones de fixation selon l'axe Z.

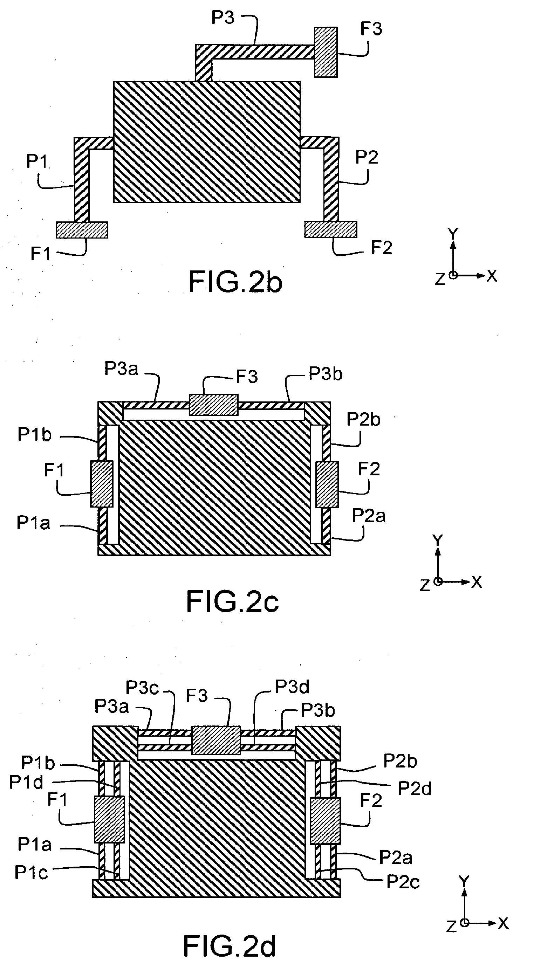

La figure 2b représente une variante du mode de réalisation de la figure 2a, dans laquelle les deux poutres P1 et P2, ont une direction sensiblement identique, et sont reliés respectivement aux bords de la partie principale du détecteur, adjacents au bord auquel est fixé la troisième poutre P3, ce qui réduit le bras de levier en rotation selon X et procure un mode de résonance plus élevé selon cette direction.

La figue 2c représente, une variante des figures 2a et 2b, d'un microsystème électromécanique dont la partie principale est de forme sensiblement rectangulaire, muni de trois éléments de fixation F1, F2 et F3, adaptés pour être fixés sur un support, par exemple un boitier d'encapsulation, au moyen des trois éléments de fixation F1, F2 et F3. Chaque élément de fixation F1, F2 et F3 est respectivement lié solidairement à deux poutres de même direction, déformables en flexion, reliant la partie principale du détecteur aux trois éléments de fixations F1, F2 et F3 du détecteur.

L'élément de fixation F1 est lié solidairement à deux poutres P1 a et P1 b, l'élément de fixation F2 est lié solidairement à deux poutres P2a et P2b et l'élément de fixation F3 est lié solidairement à deux poutres P3a et P3b Les quatre poutres P1 a, P1 b, P2a, P2b ont une direction sensiblement identique, tandis que les deux poutres P3a et P3b ont une direction sensiblement orthogonale à la direction des quatre autres poutres P1 a, P1 b, P2a, et P2b. Un tel mode de réalisation permet d'augmenter encore les raideurs en rotation selon les axes X et Y.

La figure 2d est une variante de la figure 2c, dans laquelle chaque poutre de la figure 2c est dupliquée en deux poutres parallèles. Aussi, un microsystème électromécanique dont la partie principale est de forme sensiblement rectangulaire, muni de trois éléments de fixation F1, F2 et F3, adaptés pour être fixés sur un support, par exemple un boitier d'encapsulation, au moyen des trois éléments de fixation F1, F2 et F3. Chaque élément de fixation F1, F2 et F3 est respectivement lié solidairement à deux poutres de même direction, déformables en flexion, reliant la partie principale du détecteur aux trois éléments de fixations F1, F2 et F3 du détecteur.

L'élément de fixation F1 est lié solidairement à quatre poutres P1 a, P1 b, P1c, et P1 d, l'élément de fixation F2 est lié solidairement à quatre poutres P2a, P2b, P2c, et P2d, et l'élément de fixation F3 est lié solidairement à quatre poutres P3a , P3b, P3c, et P3d. Les huit poutres P1 a, P1b, P1c, P1d, P2a , P2b, P2c, et P2d ont une direction sensiblement identique, tandis que les quatre poutres P3a , P3b, P3c, et P3d ont une direction sensiblement orthogonale à la direction des huit autres poutres P1 a, P1 b, P1 c, P1 d, P2a , P2b, P2c, et P2d. Un tel mode de réalisation permet, en multipliant le nombre de poutres, pour une raideur donnée selon les axes X, Y et Z, d'avoir des raideurs locales quatre fois plus faibles, au niveau des éléments de fixation, pour les mouvements selon l'épaisseur e de chaque poutre.

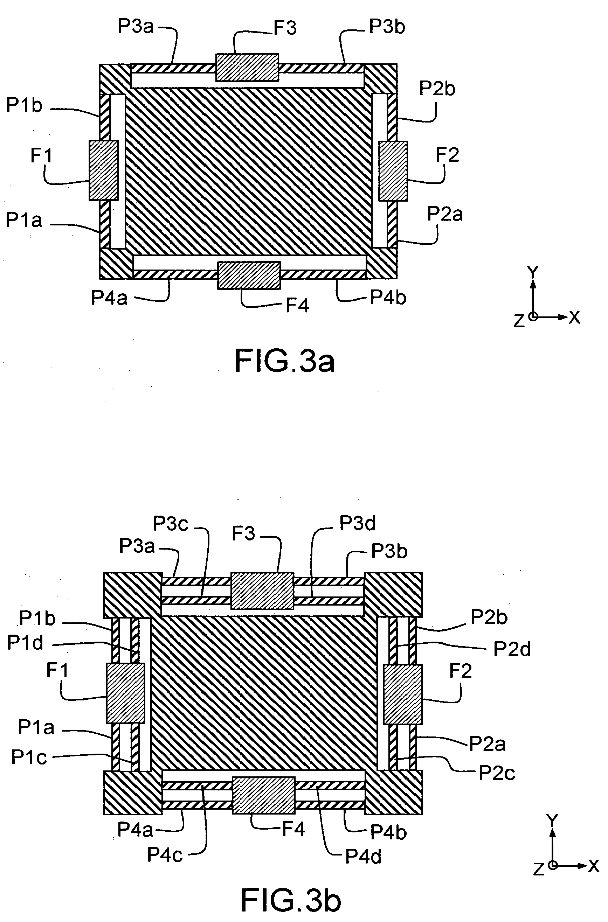

La figure 3a représente un microsystème électromécanique dont la partie principale est de forme rectangulaire, muni de quatre éléments de fixation F1, F2, F3 et F4, adaptés pour être fixés sur un support, par exemple un boitier d'encapsulation, au moyen des quatre éléments de fixation F1, F2, F3 et F4. Chaque élément de fixation F1, F2, F3 et F4 est respectivement lié solidairement à deux poutres déformables en flexion, reliant la partie principale du détecteur aux quatre éléments de fixations F1, F2, F3 et F4 du détecteur.

L'élément de fixation F1 est lié solidairement à deux poutres P1a, et P1 b, l'élément de fixation F2 est lié solidairement à deux poutres P2a, et P2b, l'élément de fixation F3 est lié solidairement à deux poutres P3a et P3b, et l'élément de fixation F4 est lié solidairement à deux poutres P4a et P4b. Les quatre poutres P1 a, P1 b, P2a, et P2b ont une direction sensiblement identique, et les quatre poutres P3a, P3b, P4a et P4b ont une direction sensiblement orthogonale à la direction des quatre autres poutres P1 a, P1 b, P2a, et P2b. Un tel mode de réalisation permet de construire une structure entièrement symétrique par rapport aux plans X, Y et par rapport à l'axe Z. C'est particulièrement favorable si la structure interne du microsystème présente elle-aussi ces axes de symétrie, pour préserver la réjection des déformations externes.

La figure 3b est une variante de la figure 3a, dans laquelle chaque poutre de la figure 3b est dupliquée en deux poutres parallèles. Aussi, un microsystème électromécanique dont la partie principale est de forme sensiblement rectangulaire, muni de quatre éléments de fixation F1, F2, F3 et F4, adaptés pour être fixés sur un support, par exemple un boitier d'encapsulation, au moyen des quatre éléments de fixation F1, F2, F3 et F4. Chaque élément de fixation F1, F2, F3 et F4 est respectivement lié solidairement à quatre poutres de même direction, déformables en flexion, reliant la partie principale du détecteur aux quatre éléments de fixations F1, F2, F3 et F4 du détecteur.

L'élément de fixation F1 est lié solidairement à quatre poutres P1 a, P1 b, P1c, et P1 d, l'élément de fixation F2 est lié solidairement à quatre poutres P2a, P2b, P2c, et P2d, l'élément de fixation F3 est lié solidairement à quatre poutres P3a , P3b, P3c, et P3d, et l'élément de fixation F3 est lié solidairement à quatre poutres P4a , P4b, P4c, et P4d. Les huit poutres P1 a, P1b, P1c, P1d, P2a, P2b, P2c, et P2d ont une direction sensiblement identique, et les huit autres poutres P3a , P3b, P3c, P3d, P4a, P4b, P4c, et P4d ont une direction sensiblement orthogonale à la direction des huit autres poutres P1a, P1b, P1c, P1d, P2a, P2b, P2c, et P2d. Un tel mode de réalisation permet, comme pour la configuration de la figure 2d, en multipliant le nombre de poutres, pour une raideur donnée selon les axes X, Y et Z, d'avoir des raideurs locales quatre fois plus faibles, au niveau des éléments de fixation pour les mouvements selon l'épaisseur e de chaque poutre.

Dans les différents modes de réalisation, les éléments de fixation permettent d'absorber des dilatations du support sur lequel sont fixés les éléments de fixation, notamment quand le support subit des dilatations dues à l'effet de la température; les poutres étant relativement souples, la force transmise à la partie principale du détecteur est ainsi fortement limitée.

En outre, en présence de vibrations ou d'accélérations appliquées aux éléments de fixation ou zones de report, par exemple horizontalement sur les figures 3a et 3b, les poutres verticales travaillent en flexion et sont donc toujours souples. Mais les poutres horizontales travaillent en traction, avec une raideur beaucoup plus importante (de l'ordre de cent fois avec les modes de réalisation des figures 3a et 3b). Le mouvement de la partie suspendue est donc très limité.

Comme les poutres présentent une forte raideur globale vis à vis des mouvements de la partie principale du détecteur en translation et en rotation, les modes de résonance de cette structure restent très élevés, typiquement au delà de 20 KHz alors qu'ils seraient de l'ordre de 2 KHz avec une architecture plus conventionnelle, ce qui permet de maîtriser les performances dans les environnements opérationnels. Les niveaux de vibrations sont en général beaucoup plus élevés dans les basses fréquences que dans les hautes fréquences.

Selon un aspect de l'invention, il est avantageux, lorsque le microsystème électromécanique est réalisé dans un matériau multicouches, de réaliser les poutres directement dans une couche de protection du matériau multicouches.

Les couches de protection sont les couches destinées à soutenir la structure active du détecteur et à protéger la structure active du détecteur des poussières et des chocs. Il est possible d'utiliser des technologies de collage ou de brasage pour fixer le microsystème électromécanique sur son support. Cela peut être mis en oeuvre sur l'ensemble des modes de réalisation selon un aspect de l'invention.

Les poutres présentent une souplesse contrôlée vis à vis des déplacements relatifs du microsystème électromécanique et du support, pouvant être un boîtier. Elles sont conçues pour être très souples pour des déplacements locaux des ancrages ou fixations sur le support car elles sont déformables par flexion. Par contre, leur combinaison permet de réaliser une fixation très raide du détecteur sur son support. Même si les coefficients de dilatation thermique sont différents entre le support et la structure du microsystème électromécanique, un déplacement entre les éléments de fixation et le support ne sera pas ou peu transmis aux éléments mobiles du détecteur.

On dit que le détecteur est suspendu par rapport au support d'accueil, car les seuls points de contact sont ici les zones de report ou fixation.

Une telle configuration permet, avec seulement trois couches, de réaliser simultanément une cavité hermétique contenant la structure active, et le système de fixation par poutres souples ce qui n'est pas possible avec l'état de l'art antérieur qui utilise au moins quatre couches

La réalisation des poutres souples dans la même couche que le capot ou couche de protection, simplifie les opérations de fabrication en diminuant le nombre de couches à assembler.

Cette configuration de poutre permet une fixation très rigide de la structure ce qui est particulièrement important pour construire des microstructures de gyromètre pour préserver les propriétés des résonateurs réalisés à l'aide des parties internes mobiles.

## Revendications

1. Microsystème électromécanique muni d'au moins deux éléments de fixation disjoints (F1, F2) pour fixer rigidement le microsystème électromécanique sur un support, **caractérisé en ce que** chaque élément de fixation (F1, F2) est lié solidairement à au moins une poutre (P1, P2) déformable en flexion, et deux poutres (P1, P2) liées respectivement à deux éléments de fixation (F1, F2) distincts ont des directions différentes, chaque poutre ayant une longueur L, une épaisseur e, et une hauteur h, telles que les raideurs KL selon les directions de la longueur et de la hauteur Kh soient fortes et la raideur selon la direction de l'épaisseur Ke soit faible.

2. Microsystème électromécanique selon la revendication 1, dans lequel deux poutres (P1, P2) liées respectivement à deux éléments de fixation (F1, F2) distincts ont des directions sensiblement orthogonales.

3. Microsystème électromécanique selon la revendication 1 ou 2, comprenant trois éléments de fixation (F1, F2, F3).

4. Microsystème électromécanique selon la revendication 3, dans lequel la ou les poutres (P1, P2) liées à deux (F1, F2) des trois éléments de fixation (F1, F2, F3) ont une direction sensiblement identique, et la ou les poutres (P3) reliées à l'autre (F3) des trois éléments de fixation (F1, F2, F3) ont une direction sensiblement orthogonale à la direction de ladite ou lesdites autres poutres (P1, P2).

5. Microsystème électromécanique selon la revendication 1 ou 2, comprenant quatre éléments de fixation (F1, F2, F3, F4).

6. Microsystème électromécanique selon la revendication 5, dans lequel la ou les poutres (P1 a, P1 b, P2a, P2b) liées à deux (F1, F2) des quatre éléments de fixation (F1, F2, F3, F4) ont une direction sensiblement identique, et la ou les poutres (P3a, P3b, P4a, P4b) reliées au deux autres (F3, F4) des quatre éléments de fixation (F1, F2, F3, F4) ont une direction sensiblement orthogonale à la direction de ladite ou lesdites autres poutres (P1 a, P1b, P2a, P2b).

7. Microsystème électromécanique selon l'une des revendications précédentes, dans lequel des poutres liées solidairement à un même élément de fixation ont sensiblement la même direction.

8. Microsystème électromécanique selon l'une des revendications précédentes, dans lequel un élément de fixation est lié solidairement à quatre poutres.

9. Microsystème électromécanique selon l'une des revendications précédentes, dans lequel, ledit microsystème électromécanique étant réalisé dans un matériau multicouches comprenant au moins une couche active et deux couches de protection de part et d'autre de la couche active, lesdites poutres sont réalisées dans l'une des deux couches de protection.

10. Procédé de fixation d'un microsystème électromécanique muni d'au moins deux éléments de fixation disjoints (F1, F2) pour fixer rigidement le microsystème électromécanique sur un support, en liant solidairement chaque élément de fixation (F1, F2) à au moins une poutre (P1, P2) déformable en flexion, deux poutres (P1, P2) liées respectivement à deux éléments de fixation (F1, F2) distincts ayant des directions différentes, chaque poutre ayant une longueur L, une épaisseur e, et une hauteur h, telles que les raideurs KL selon les directions de la longueur et de la hauteur Kh soient fortes et la raideur selon la direction de l'épaisseur Ke soit faible.

11. Procédé selon la revendication 10, dans lequel ladite liaison est effectuée par brasage et/ou soudage et/ou collage.

## Patentansprüche

1. Mikroelektromechanisches System, das mit wenigstens zwei separaten Befestigungselementen (F1, F2) zum starren Befestigen des mikroelektromechanischen Systems an einem Halter versehen ist, **dadurch gekennzeichnet, dass** jedes Befestigungselement (F1, F2) starr mit wenigstens einem biegeverformbaren Träger (P1, P2) verbunden ist und zwei jeweils mit zwei getrennten Befestigungselementen (F1, F2) verbundene Träger (P1, P2) verschiedene Richtungen haben, wobei jeder Träger eine Länge L, eine Dicke e und eine Höhe h hat, so dass die Steifigkeiten KL in der Längen- und der Höhen- Kh -richtung hoch sind und die Steifigkeit in der Dickenrichtung Ke niedrig ist.

2. Mikroelektromechanisches System nach Anspruch 1, wobei zwei jeweils mit zwei getrennten Befestigungselementen (F1, F2) verbundene Träger (P1, P2) im Wesentlichen orthogonale Richtungen haben.

3. Mikroelektromechanisches System nach Anspruch 1 oder 2, das drei Befestigungselemente (F1, F2, F3) umfasst.

4. Mikroelektromechanisches System nach Anspruch 3, wobei die mit zwei (F1, F2) der drei Befestigungselemente (F1, F2, F3) verbundenen ein oder mehreren Träger (P1, P2) eine im Wesentlichen identische Richtung haben und die mit dem anderen (F3) der drei Befestigungselemente (F1, F2, F3) verbundenen ein oder mehreren Träger (P3) eine Richtung haben, die im Wesentlichen orthogonal zur Richtung der ein oder mehreren anderen Träger (P1, P2) ist.

5. Mikroelektromechanisches System nach Anspruch 1 oder 2, das vier Befestigungselemente (F1, F2, F3, F4) umfasst.

6. Mikroelektromechanisches System nach Anspruch 5, wobei die mit zwei (F1, F2) der vier Befestigungselemente (F1, F2, F3, F4) verbundenen ein oder mehreren Träger (P1a, P1b, P2a, P2b) eine im Wesentlichen identische Richtung haben und die mit den anderen beiden (F3, F4) der vier Befestigungselemente (F1, F2, F3, F4) verbundenen ein oder mehreren Träger (P3a, P3b, P4a, P4b) eine Richtung haben, die im Wesentlichen orthogonal zur Richtung der ein oder mehreren anderen Träger (P1a, P1b, P2a, P2b) ist.

7. Mikroelektromechanisches System nach einem der vorherigen Ansprüche, wobei starr mit demselben Befestigungselement verbundene Träger im Wesentlichen dieselbe Richtung haben.

8. Mikroelektromechanisches System nach einem der vorherigen Ansprüche, wobei ein Befestigungselement starr mit vier Trägern verbunden ist.

9. Mikroelektromechanisches System nach einem der vorherigen Ansprüche, wobei, wenn das mikroelektromechanische System aus einem mehrschichtigen Material gebildet ist, das wenigstens eine aktive Schicht und zwei Schutzschichten auf beiden Seiten der aktiven Schicht umfasst, die Träger in einer der zwei Schutzschichten erzeugt werden.

10. Verfahren zum Befestigen eines mikroelektromechanischen Systems, das mit wenigstens zwei separaten Befestigungselementen (F1, F2) zum starren Befestigen des mikroelektromechanischen Systems an einer Stütze durch starres Verbinden jedes Befestigungselements (F1, F2) mit wenigstens einem biegeverformbaren Träger (P1, P2) versehen ist, wobei zwei Träger jeweils mit zwei getrennten Befestigungselementen (F1, F2) mit verschiedenen Richtungen verbunden sind, wobei jeder Träger eine Länge L, eine Dicke e und eine Höhe h hat, so dass die Steifigkeiten KL in der Längen- und in der Höhen- Kh -richtung hoch sind und die Steifigkeit in der Dickenrichtung Ke niedrig ist.

11. Verfahren nach Anspruch 10, wobei die Verbindung durch Hartlöten und/oder durch Löten und/oder durch Kleben realisiert wird.

## Claims

1. A microelectromechanical system provided with at least two separate attachment elements (F1, F2) for rigidly attaching said microelectromechanical system to a support, **characterised in that** each attachment element (F1, F2) is rigidly connected to at least one beam (P1, P2) that is deformable by flexure, and two beams (P1, P2) respectively connected to two distinct attachment elements (F1, F2) have different directions, each beam having a length L, a thickness e and a height h, such that the stiffnesses KL in the length and the height Kh directions are high and the stiffness in the thickness Ke direction is low.

2. The microelectromechanical system according to claim 1, wherein said two beams (P1, P2) respectively connected to two distinct attachment elements (F1, F2) have substantially orthogonal directions.

3. The microelectromechanical system according claim 1 or 2, comprising three attachment elements (F1, F2, F3).

4. The microelectromechanical system according to claim 3, wherein the one or more beams (P1, P2) connected to two (F1, F2) of said three attachment elements (F1, F2, F3) have a substantially identical direction, and the one or more beams (P3) connected to the other (F3) of said three attachment elements (F1, F2, F3) have a direction that is substantially orthogonal to the direction of said one or more other beams (P1, P2).

5. The microelectromechanical system according to claim 1 or 2, comprising four attachment elements (F1, F2, F3, F4).

6. The microelectromechanical system according to claim 5, wherein the one or more beams (P1a, P1b, P2a, P2b) connected to two (F1, F2) of said four attachment elements (F1, F2, F3, F4) have a substantially identical direction, and the one or more beams (P3a, P3b, P4a, P4b) connected to the other two (F3, F4) of said four attachment elements (F1, F2, F3, F4) have a direction that is substantially orthogonal to the direction of said one or more other beams (P1a, P1b, P2a, P2b).

7. The microelectromechanical system according to any one of the preceding claims, wherein beams that are rigidly connected to the same attachment element have substantially the same direction.

8. The microelectromechanical system according to any one of the preceding claims, wherein an attachment element is rigidly connected to four beams.

9. The microelectromechanical system according to any one of the preceding claims, wherein, with said microelectromechanical system being made of a multilayered material comprising at least one active layer and two protective layers either side of said active layer, said beams are produced in one of said two protective layers.

10. A method for attaching a microelectromechanical system provided with at least two separate attachment elements (F1, F2) for rigidly attaching said microelectromechanical system to a support by rigidly connecting each attachment element (F1, F2) to at least one beam (P1, P2) that is deformable by flexure, with two beams respectively connected to two distinct attachment elements (F1, F2) having different directions, each beam having a length L, a thickness e and a height h, such that the stiffnesses KL in the length and the height Kh directions are high and the stiffness in the thickness Ke direction is low.

11. The method according to claim 10, wherein said connection is realised by brazing and/or by soldering and/or by gluing.
